# EUROPEAN PATENT APPLICATION

(11) **EP 4 823 296 A1**
(43) Date of publication of application: **14.10.2026**
(21) Application number: 25760661.6
(22) Date of filing: 14.01.2025
(51) Int. Cl.: H10K 59/126, H10K 59/131, H10K 59/40, G06F 3/041

(54) **DISPLAY SUBSTRATE AND DISPLAY DEVICE**

(30) Priority: 29.02.2024 CN 202410233198
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: ZENG, Yang, Beijing 100176 (CN); LIU, Jianghua, Beijing 100176 (CN); LUO, Peng, Beijing 100176 (CN); MA, Hongwei, Beijing 100176 (CN); ZHANG, Yi, Beijing 100176 (CN)
(74) Representative: Cohausz & Florack
(86) International application number: PCT/CN2025/072248
(87) International publication number: WO 2025/180117

(57) **Abstract**

Disclosed are a display substrate and a display apparatus. The display substrate includes a substrate, a light-emitting structure layer on a side of the substrate, a touch layer on a side of the light-emitting structure layer away from the substrate, at least two touch signal line groups, and a shield line. The touch layer includes a plurality of touch electrodes. Each touch signal line group includes a plurality of touch signal lines each connected to a touch electrode. At least part of the touch signal lines each include a first section and a second section connected with each other, and second sections in a same touch signal line group are adjacent to each other. The shield line includes a first shield section and two second shield sections, the first shield section is at least partially between two adjacent first sections, and each second shield section is between second sections in two adjacent touch signal line groups. In two adjacent touch signal line groups, the second section in one touch signal line group adjacent to the other touch signal line group is adjacent to one of the two second shield sections, while the two second shield sections are electrically connected to the first shield section.

## Description

### TECHNICAL FIELD

The present application relates to the field of display technology, and in particular relates to a display substrate and a display apparatus.

### BACKGROUND

With the development of technology, electronic devices with a touch function have occupied the major market of electronic devices. Due to the advantages of high touch precision and sensitivity, and the like, touch film layers with a metal grid structure are widely applied in electronic devices.

In the existing electrical equipment, touch signal lines in a touch film layer can be easily interfered with and thus affect the touch precision.

### SUMMARY

The present application provides a display substrate and a display apparatus.

According to a first aspect of the embodiments of the present application, there is provided a display substrate. The display substrate includes:
a substrate;
a light-emitting structure layer on a side of the substrate;
a touch layer on a side of the light-emitting structure layer away from the substrate, wherein the touch layer includes a plurality of touch electrodes;
at least two touch signal line groups, each of which includes a plurality of touch signal lines, wherein all touch signal lines are electrically connected to the plurality of touch electrodes, respectively, at least part of the touch signal lines each include a first section and a second section connected with each other, and second sections in a same touch signal line group are adjacent to each other; and
a shield line, including a first shield section and two second shield sections, the first shield section is at least partially between two adjacent first sections, and each second shield section is in a gap between second sections in two adjacent touch signal line groups; and in two adjacent touch signal line groups, the second section in one touch signal line group adjacent to the other touch signal line group is adjacent to one of the two second shield sections, while the two second shield sections are electrically connected to the first shield section.

In one embodiment, the first shield section is between two adjacent touch signal lines in the same touch signal line group, and the shield line further includes a connection section connecting the first shield section and the two second shield sections; and the display substrate further includes a bonding terminal connected to the first shield section.

In one embodiment, the first shield section is partially between two adjacent second sections in the same touch signal line group, the second section between the second shield section connected to the connection section and the first shield section includes a first sub-section, and an orthographic projection of the first sub-section on the substrate is overlapped with an orthographic projection of the connection section on the substrate; and the first sub-section is in a different conductive layer from the connection section.

In one embodiment, in a same shield line, the two second shield sections are connected with each other, and the connection section is connected to one of the two second shield sections.

In one embodiment, the display substrate further includes a first conductive layer between the light-emitting structure layer and the substrate, and the first sub-section is in the first conductive layer; and the connection section is in a conductive layer in the touch layer.

In one embodiment, the display substrate includes a display area and a non-display area, wherein the non-display area includes a transition area, a bending area and a bonding area, the bending area adjoins the transition area and the bonding area, and the display area is adjacent to the transition area; the bonding area is on a side of the display area facing away from a display surface; the first section and at least part of the first shield section is in the transition area, and the second section and the two second shield sections are in the transition area, the bending area and the bonding area; and the first sub-section and the connection section are in the bending area; and
the display substrate further includes a second conductive layer between the first conductive layer and the light-emitting structure layer; the second section further includes a second sub-section in the bending area and connected to the first sub-section; and the second sub-section is in the second conductive layer.

In one embodiment, the touch layer includes a third conductive layer, and a fourth conductive layer on a side of the third conductive layer away from the substrate; and the connection section is in the fourth conductive layer.

In one embodiment, the display substrate further includes a plurality of pixel circuits between the light-emitting structure layer and the substrate, wherein part of structures of the pixel circuits are in the first conductive layer.

In one embodiment, the touch layer includes a third conductive layer, and a fourth conductive layer on a side of the third conductive layer away from the substrate; and the connection section is in the third conductive layer, and the first sub-section is in the fourth conductive layer; or the connection section is in the fourth conductive layer, and the first sub-section is in the third conductive layer.

In one embodiment, the display substrate includes a display area and a non-display area, wherein the non-display area includes a transition area, a bending area and a bonding area, the bending area adjoins the transition area and the bonding area, and the display area is adjacent to the transition area; the bonding area is on a side of the display area facing away from a display surface; the first section and at least part of the first shield section is in the transition area, and the second section and the two second shield sections are in the transition area, the bending area and the bonding area; and
the connection section is in the transition area or the bonding area.

In one embodiment, the first shield section is between two adjacent touch signal line groups, and in a same shield line, the two second shield sections are directly connected to the first shield section.

In one embodiment, the display substrate includes a display area and a non-display area, wherein the non-display area includes a transition area, a bending area and a bonding area, the bending area adjoins the transition area and the bonding area, and the display area is adjacent to the transition area; the bonding area is on a side of the display area facing away from a display surface; the first section and at least part of the first shield section is in the transition area, and the second section and the two second shield sections are in the transition area, the bending area and the bonding area; and
the shield line further includes a third shield section in the bonding area and between two adjacent touch signal line groups; in a same shield line, the two second shield sections are each directly connected to a same third shield section; and the display substrate further includes a bonding terminal in the bonding area and connected to the third shield section.

In one embodiment, the display substrate further includes a ground signal line including a first ground signal section and a second ground signal section, wherein the first ground signal section and the second ground signal section are between the two second shield sections of a same shield line, and adjacent to different second shield sections, respectively.

In one embodiment, the ground signal line further includes a third ground signal section; the first ground signal section and the second ground signal section are each connected to a same third ground signal section, and the display substrate further includes a bonding terminal connected to the third ground signal section.

In one embodiment, the display substrate includes a display area and a non-display area, wherein the non-display area includes a transition area, a bending area and a bonding area, the bending area adjoins the transition area and the bonding area, and the display area is adjacent to the transition area; the bonding area is on a side of the display area facing away from a display surface; the first section and at least part of the first shield section is in the transition area, and the second section and the two second shield sections are in the transition area, the bending area and the bonding area; and the bonding terminal is in the bonding area; and
the shield line further includes a third shield section in the bonding area and connected to the bonding terminal and adjacent to the third ground signal section.

In one embodiment, the ground signal line further includes a fourth ground signal section and a fifth ground signal section; the first ground signal section is connected to the second ground signal section; and the fourth ground signal section is on a same side of the at least two touch signal line groups, and connected to the first ground signal section through the fifth ground signal section; and
the display substrate further includes a bonding terminal connected to the fourth ground signal section.

In one embodiment, the ground signal line includes a fourth ground signal section and a fifth ground signal section; the first ground signal section is connected to the second ground signal section; and the fourth ground signal section is between two adjacent touch signal lines in the same touch signal line group and adjacent to the first shield section, and connected to the first ground signal section through the fifth ground signal section; and
the display substrate further includes a bonding terminal connected to the fourth ground signal section.

In one embodiment, the display substrate further includes a first conductive layer between the light-emitting structure layer and the substrate; the second section includes a first sub-section, and the second shield section includes a third sub-section; an orthographic projection of the fifth ground signal section on the substrate is overlapped with an orthographic projection of the first sub-section on the substrate, and overlapped with an orthographic projection of the third sub-section on the substrate; the first sub-section and the third sub-section are in the first conductive layer; and
the fifth ground signal section is in a conductive layer in the touch layer.

In one embodiment, the display substrate includes a display area and a non-display area, wherein the non-display area includes a transition area, a bending area and a bonding area, the bending area adjoins the transition area and the bonding area, and the display area is adjacent to the transition area; the bonding area is on a side of the display area facing away from a display surface; the first section and at least part of the first shield section is in the transition area, and the second section and the two second shield sections are in the transition area, the bending area and the bonding area; and the first sub-section, the third sub-section and the fifth ground signal section are in the bending area; and
the display substrate further includes a second conductive layer between the first conductive layer and the light-emitting structure layer; the second section further includes a second sub-section in the bending area and connected to the first sub-section, and the second shield section further includes a fourth sub-section in the bending area and connected to the third sub-section; and the second sub-section and the fourth sub-section are in the second conductive layer.

In one embodiment, the second section includes a first sub-section; the second shield section includes a third sub-section, and an orthographic projection of the fifth ground signal section on the substrate is overlapped with an orthographic projection of the first sub-section on the substrate, and overlapped with an orthographic projection of the third sub-section on the substrate; and
the touch layer includes a third conductive layer, and a fourth conductive layer on a side of the third conductive layer away from the substrate; and the fifth ground signal section is in the third conductive layer, and the first sub-section and the third sub-section are in the fourth conductive layer; or the fifth ground signal section is in the fourth conductive layer, and the first sub-section and the third sub-section are in the third conductive layer.

In one embodiment, the display substrate includes a display area and a non-display area, wherein the non-display area includes a transition area, a bending area and a bonding area, the bending area adjoins the transition area and the bonding area, and the display area is adjacent to the transition area; the bonding area is on a side of the display area facing away from a display surface; the first section and at least part of the first shield section is in the transition area, and the second section and the two second shield sections are in the transition area, the bending area and the bonding area; and
the fifth ground signal section is in the transition area or the bonding area.

In one embodiment, the plurality of touch electrodes include a plurality of first touch electrodes and a plurality of second touch electrodes, wherein one of each first touch electrode or each second touch electrode is a touch drive electrode, and the other is a touch sense electrode; the plurality of touch signal lines include a plurality of first touch signal lines and a plurality of second touch signal lines, wherein the first touch signal lines are connected to the first touch electrodes, and the second touch signal lines are connected to the second touch electrodes; and the first touch signal lines and the second touch signal lines in two adjacent touch signal line groups are on two sides of the first shield section.

In one embodiment, the display substrate includes a display area and a non-display subarea on a side of the display area, wherein the shield line and the touch signal lines are in the non-display subarea; and a direction pointing from the display area to the non-display subarea is a first direction; and
each second shield section is in a portion of the non-display subarea, and a width of a portion of the second shield section extending in the first direction is greater than a width of a portion of the second shield section extending in a second direction intersecting the first direction; and/or, each touch signal line is in a portion of the non-display subarea, and a width of a portion of the touch signal line extending in the first direction is greater than a width of a portion of the touch signal line extending in a second direction intersecting the first direction.

In one embodiment, each touch signal line further includes a third section connected to an end of the second section away from the first section, and a maximum distance between third sections in two adjacent touch signal line groups is less than a maximum distance between second sections in two adjacent touch signal line groups; the shield line further includes a third shield section between two adjacent third sections; and The display substrate further includes bonding terminals connected to each third section and the third shield section.

According to a second aspect of the embodiments of the present application, there is provided a display apparatus, including the display substrate as described above.

According to the display substrate and the display apparatus provided in the embodiments of the present application, the first shield section of the shield line is between two adjacent touch signal lines, so that the first shield section can shield signal interference between the touch signal lines on two sides of the first shield section; and by providing the two second shield sections of the shield line in the gap between the second sections in two adjacent touch signal line groups, and the second section in one touch signal line group adjacent to the other touch signal line group to be adjacent to one of the two second shield sections, the second shield section adjacent to each touch signal line group can prevent electrostatic charges from being delivered to the touch signal lines in the touch signal line groups, and avoid the interference of other signal lines between the two second shield sections to the touch signal lines. In other words, the interference with the touch signal lines in each touch signal line group can be reduced, and the touch precision of the display substrate can be improved.

### BRIEF DESCRIPTION OF DRAWINGS

FIG. 1 is a schematic trace layout of a display subarea in an extended state in a display substrate according to an exemplary embodiment of the present application;
FIG. 2A is a partial cross-sectional view of a display substrate according to an exemplary embodiment of the present application;
FIG. 2B is a schematic structural diagram of a display substrate according to an exemplary embodiment of the present application;
FIG. 2C is a partial structural diagram of a display substrate according to an exemplary embodiment of the present application;
FIG. 3 is a cross-sectional view of the display substrate shown in FIG. 1 taken along AA;
FIG. 4 is an enlarged view of one area in the display substrate shown in FIG. 1;
FIG. 5 is an enlarged view of another area in the display substrate shown in FIG. 1;
FIG. 6 is a schematic trace layout of a display subarea in an extended state in a display substrate according to another exemplary embodiment of the present application;
FIG. 7 is a schematic trace layout of a display subarea in an extended state in a display substrate according to yet another exemplary embodiment of the present application;
FIG. 8 is an enlarged view of one area of the display substrate shown in FIGs. 6 and 7;
FIG. 9 is a cross-sectional view of the display substrate shown in FIG. 8 taken along BB;
FIG. 10 is a cross-sectional view of the display substrate shown in FIG. 8 taken along CC;
FIG. 11 is a schematic trace layout of a display subarea in an extended state in a display substrate according to still another exemplary embodiment of the present application;
FIG. 12 is a partial enlarged view of the display substrate shown in FIG. 11;
FIG. 13 is a schematic trace layout of a display subarea in an extended state in a display substrate according to still another exemplary embodiment of the present application;
FIG. 14 is a schematic trace layout of a display subarea in an extended state in a display substrate according to still another exemplary embodiment of the present application;
FIG. 15 is a partial enlarged view of the display substrate shown in FIG. 14;
FIG. 16 is a schematic trace layout of a display subarea in an extended state in a display substrate according to still another exemplary embodiment of the present application;
FIG. 17 is a partial enlarged view of the display substrate shown in FIG. 16; and
FIG. 18 is a schematic trace layout of a display subarea in an extended state in a display substrate according to still another exemplary embodiment of the present application.

### DETAIL DESCRIPTION OF EMBODIMENTS

Here, exemplary embodiments will be illustrated in detail, examples of which are shown in the accompanying drawings. The following description refers to the accompanying drawings in which the same numbers in different drawings represent the same or similar elements unless otherwise indicated. The embodiments described in the following exemplary embodiments do not represent all embodiments consistent with the present application. Rather, they are merely examples of apparatuses and methods consistent with certain aspects of the present application, as detailed in the appended claims.

The terminology used in the present application is for the purpose of describing particular embodiments only, and is not intended to limit the present application. As used in the present application and the appended claims, the singular forms "a", "an", and "the" are intended to include the plural forms as well, unless the context clearly indicates otherwise. It should also be understood that the term "and/or" as used herein refers to and encompasses any and all possible combinations of one or more of the associated listed items.

It is to be understood that although the terms "first", "second", "third", and the like may be used in the present application to describe various information, such information should not be limited by these terms. These terms are only used to distinguish information of the same type. For example, first information may also be referred to as second information, and similarly, second information may also be referred to as first information, without departing from the scope of the present application. The word "if", as used herein, may be interpreted as "when ..." or "upon ..." or "in response to determining ..." depending on the context.

Embodiments of the present application provide a display substrate and a display apparatus. Hereinafter, the display substrate and the display apparatus provided in the embodiments of the present application will be described in detail with reference to the accompanying drawings. Features of the embodiments described below may complement or be combined with each other without conflict.

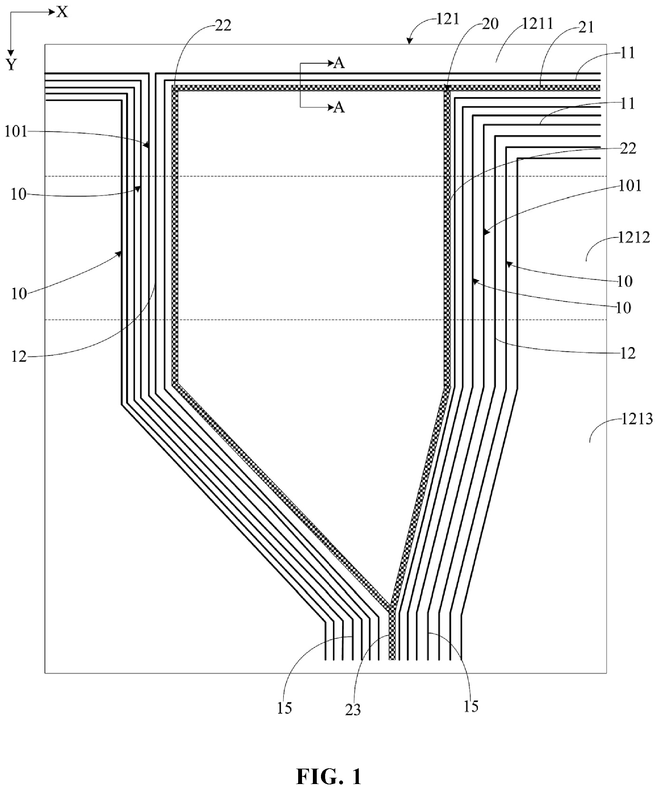

An embodiment of the present application provides a display substrate. The display substrate includes a substrate, a light-emitting structure layer on a side of the substrate, a touch layer, at least two touch signal line groups, and a shield line. The light-emitting structure layer is on a side of the substrate. The touch layer is on a side of the light-emitting structure layer away from the substrate. The touch layer includes a plurality of touch electrodes. As shown in FIG. 1, each touch signal line group 101 includes a plurality of touch signal lines 10, and all touch signal lines 10 are electrically connected to the plurality of touch electrodes, respectively. At least part of the touch signal lines 10 each include a first section 11 and a second section 12 connected with each other. Second sections 12 in the same touch signal line group 101 are adjacent to each other. A shield line 20 is further provided, which includes a first shield section 21 and two second shield sections 22. The two second shield sections 22 are electrically connected to the first shield section 21, the first shield section 21 is at least partially between two adjacent first sections 11, and each second shield section 22 is in a gap between second sections 12 in two adjacent touch signal line groups 101. In two adjacent touch signal line groups 101, the second section 12 in one touch signal line group 101 adjacent to the other touch signal line group 101 is adjacent to one of the two second shield sections 22. In two adjacent touch signal line groups 101, the second section 12 in one touch signal line group 101 closest to the other touch signal line group 101 is an innermost second section 12 in the one touch signal line group, and a gap between the innermost second sections 12 in the two adjacent touch signal line groups 101 is the gap between the second sections 12 in the two adjacent touch signal line groups 101. In two adjacent touch signal line groups 101, the second section 12 in one touch signal line group 101 adjacent to the other touch signal line group 101 refers to the second section 12 in one touch signal line group closest to the other touch signal line group 101. In two adjacent touch signal line groups 101, the fact that the second section 12 in one touch signal line group 101 adjacent to the other touch signal line group 101 is adjacent to one of the two second shield sections 22 means that no other signal line is disposed between the innermost second section 12 in the one touch signal line group 101 and the adjacent second shield section 22.

In the display substrate provided in the embodiments of the present application, the first shield section of the shield line is between two adjacent touch signal lines, so that the first shield section can shield signal interference between the touch signal lines on two sides of the first shield section; and by providing the two second shield sections of the shield line in the gap between the second sections in two adjacent touch signal line groups, and the second section in one touch signal line group adjacent to the other touch signal line group to be adjacent to one of the two second shield sections, the second shield section adjacent to each touch signal line group can prevent electrostatic charges from being delivered to the touch signal lines in the touch signal line groups, and avoid the interference of other signal lines between the two second shield sections to the touch signal lines. In other words, the interference with the touch signal lines in each touch signal line group can be reduced, and the touch precision of the display substrate can be improved.

In one embodiment, the substrate may be a flexible substrate made of a material including one or more of polyimide (PI), polyethylene terephthalate (PET) and polycarbonate (PC). In other embodiments, the substrate may be a rigid substrate made of, for example, glass, metal, plastic, and the like.

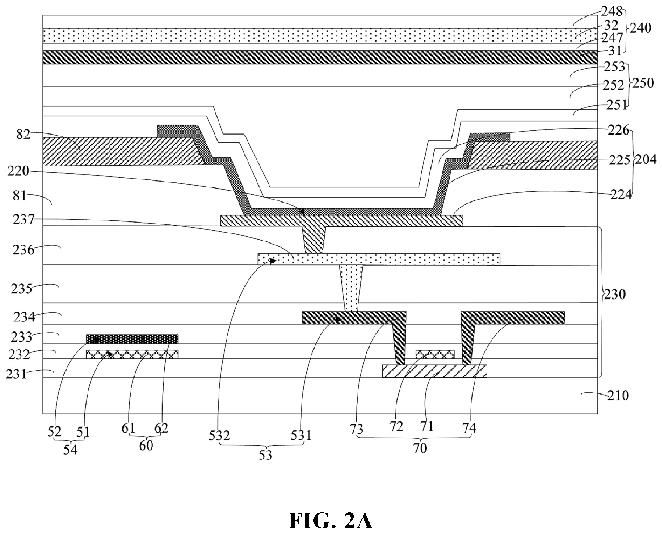

In one embodiment, as shown in FIG. 2A, the light-emitting structure layer 220 includes a plurality of light-emitting structures 204, each of which includes a first electrode 224, a luminescent material layer 225 on a side of the first electrode 224 away from the substrate 210, and a second electrode 226 on a side of the luminescent material layer 225 away from the substrate 210. One of the first electrode 224 or the second electrode 226 is an anode, while the other is a cathode. For example, the first electrode 224 is an anode, and the second electrode 226 is a cathode. Second electrodes 226 of the respective light-emitting structures 204 may be connected into a surface electrode. The luminescent material layer 225 may include an organic luminescent material.

In one embodiment, as shown in FIG. 2A, the display substrate further includes a pixel defining layer 81 on a side of the first electrode 224 away from the substrate 210, and a support pillar 82 on a side of the pixel defining layer 81 away from the substrate 210. The pixel defining layer 81 is provided with a plurality of pixel openings in one-to-one correspondence with the light-emitting structures 204. Each pixel opening partially exposes the first electrode 224 of the corresponding light-emitting structure 204, and the luminescent material layer 225 and the second electrode 226 of the light-emitting structure 204 are partially in the pixel opening.

In one embodiment, as shown in FIG. 2A, the display substrate further includes a pixel circuit layer 230 between the substrate 210 and the light-emitting structure layer 220. The pixel circuit layer 230 includes a plurality of pixel circuits. Each pixel circuit may include a thin film transistor 70, which may include an active layer 71, a gate 72, a first pole 73, and a second pole 74. One of the first pole 73 or the second pole 74 is a source, while the other is a drain. The pixel circuit may further include a capacitor 60 including a first plate 61 and a second plate 62 disposed oppositely. The pixel circuits may be provided in one-to-one correspondence with the light-emitting structures, and each pixel circuit is configured to drive the corresponding light-emitting structure. The pixel circuit layer may further include a plurality of signal lines, such as scan signal lines, data signal lines, power signal lines, and the like.

In one embodiment, as shown in FIG. 2A, the pixel circuit layer 230 includes a first conductive layer 54, and a second conductive layer 53 on a side of the first conductive layer 54 away from the substrate 210. Some structures of the pixel circuits are in the first conductive layer 54, while other structures are in the second conductive layer 53. The first conductive layer 54 may include a first conductive sub-layer 51, and a second conductive sub-layer 52 on a side of the first conductive sub-layer 51 away from the substrate 210. The second conductive layer 53 may include a third conductive sub-layer 531, and a fourth conductive sub-layer 532 on a side of the third conductive sub-layer 531 away from the substrate.

In some embodiments, as shown in FIG. 2A, the gate 72 and the first plate 61 of the capacitor 60 are in the first conductive sub-layer 51, the second plate 62 of the capacitor 60 is in the second conductive sub-layer 52, and the first pole 73 and the second pole 74 are in the third conductive sub-layer 531. The pixel circuit layer 230 further includes a connection structure 237 in the fourth conductive sub-layer 532, through which the first electrode 224 of the light-emitting structure 204 is electrically connected to the first electrode 73. The scan signal line may be in the first conductive sub-layer 51, the data signal line may be in the third conductive sub-layer 531, and the power signal line may be in the fourth conductive sub-layer.

In one embodiment, as shown in FIG. 2A, the pixel circuit layer 230 further includes a gate insulation layer 231 between the active layer 71 and the first conductive sub-layer 51, a capacitor insulation layer 232 between the first conductive sub-layer 51 and the second conductive sub-layer 52, an interlayer dielectric layer 233 between the second conductive sub-layer 52 and the third conductive sub-layer 531, a passivation layer 234 and a first planarization layer 235 between the third conductive sub-layer 531 and the fourth conductive sub-layer 532, and a second planarization layer 236 between the fourth conductive sub-layer 532 and the first electrode 224. The first electrode 224 is electrically connected to the connection structure 237 via a through hole running through the second planarization layer 236, the connection structure 237 is electrically connected to the first electrode 73 via a through hole running through the passivation layer 234 and the first planarization layer 235, and the first pole 73 and the second pole 74 are in contact with the active layer 71 via through holes running through the interlayer dielectric layer 233, the capacitor insulation layer 232, and the gate insulation layer 231, respectively.

In one embodiment, as shown in FIG. 2A, the display substrate further includes an encapsulation layer 250 between the light-emitting structure layer 220 and the touch layer 240. The encapsulation layer can be a thin film encapsulation layer, including organic and inorganic layers alternately arranged, and the farthest film layer from the substrate in the encapsulation layer is an inorganic layer. In the embodiment shown in FIG. 2A, the encapsulation layer 250 includes an inorganic layer 251, an organic layer 252 on a side of the inorganic layer 251 away from the substrate 210, and an inorganic layer 253 on a side of the organic layer 252 away from the substrate 210.

In one embodiment, as shown in FIG. 2A, the touch layer 240 includes a third conductive layer 31, and a fourth conductive layer 32 on a side of the third conductive layer 31 away from the substrate 210. The touch layer 240 further includes a first insulation layer 247 between the third conductive layer 31 and the fourth conductive layer 32, and a second insulation layer 248 on a side of the fourth conductive layer 32 away from the substrate 210. The first touch electrode and the second touch electrode may both be in the fourth conductive layer 32.

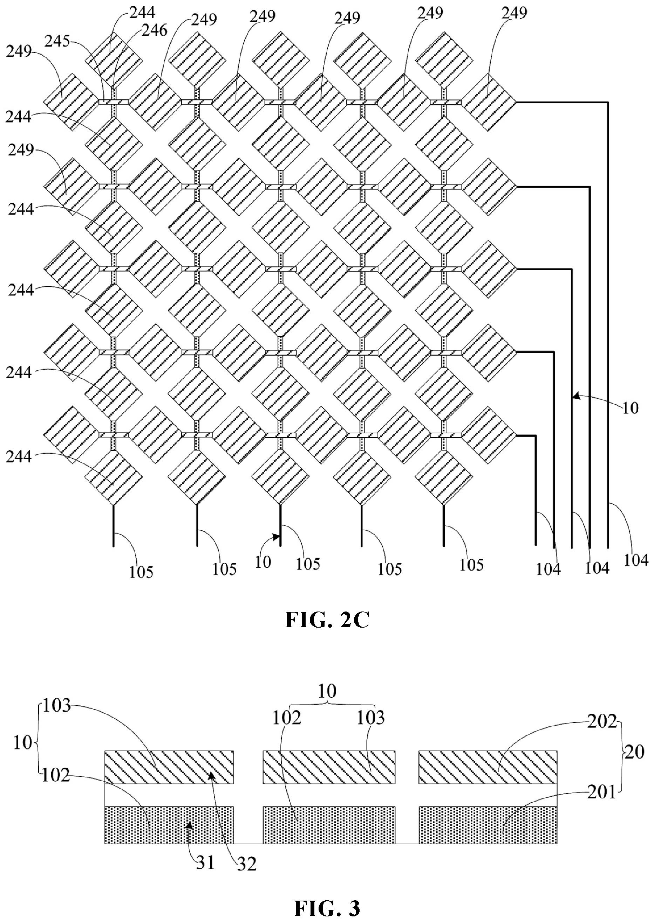

In one embodiment, as shown in FIG. 2C, the plurality of touch electrodes in the touch layer include a plurality of first touch electrodes 249 and a plurality of second touch electrodes 244. One of the first touch electrode 249 or the second touch electrode 244 is a touch drive electrode, and the other is a touch sense electrode. The first touch electrode and the second touch electrode are in the fourth conductive layer 32. In one embodiment, as shown in FIG. 2C, the plurality of first touch electrodes 249 in the touch layer are arranged in multiple rows, the plurality of second touch electrodes 244 are arranged in multiple columns, and the touch layer 240 further includes a first connection part 245 and a second connection part 246. Among the first touch electrodes 249 in the same row, adjacent first touch electrodes 249 are connected through the first connection part 245. Among the second touch electrodes 244 in the same column, adjacent second touch electrodes 244 are connected through the second connection part 246. The second connection part 246 may be in the third conductive layer 31, the first connection part 245 may be in the fourth conductive layer 32, and adjacent second touch electrodes 244 are connected to the second connection part 246 via a through hole running through the first insulation layer.

In one embodiment, as shown in FIG. 2C, the plurality of touch signal lines 10 in the display substrate include a plurality of first touch signal lines 104 and a plurality of second touch signal lines 105. The first touch electrodes 249 in the same row are connected to one of the first touch signal lines 104, and the second touch electrodes 244 in the same column are connected to one of the second touch signal lines 105. In two adjacent touch signal line groups, the first touch signal lines 104 are adjacent, the second touch signal lines 105 are adjacent, and the first touch signal lines 104 and the second touch signal lines 105 are on two opposite sides of the first shield section 21 of the shield line 20. In this manner, the shield line 20 can prevent signal crosstalk between the first touch signal lines 104 and the second touch signal lines 105.

In one embodiment, the third conductive layer and the fourth conductive layer each include a plurality of grid-like structures. An orthographic projection of each light-emitting structure on the substrate falls within an orthographic projection of one grid-like structure on the substrate.

In one embodiment, the shield line 20 may be connected to a constant electrical signal, or signals of the shield line 20 and the touch signal line 10 may both be square wave signals.

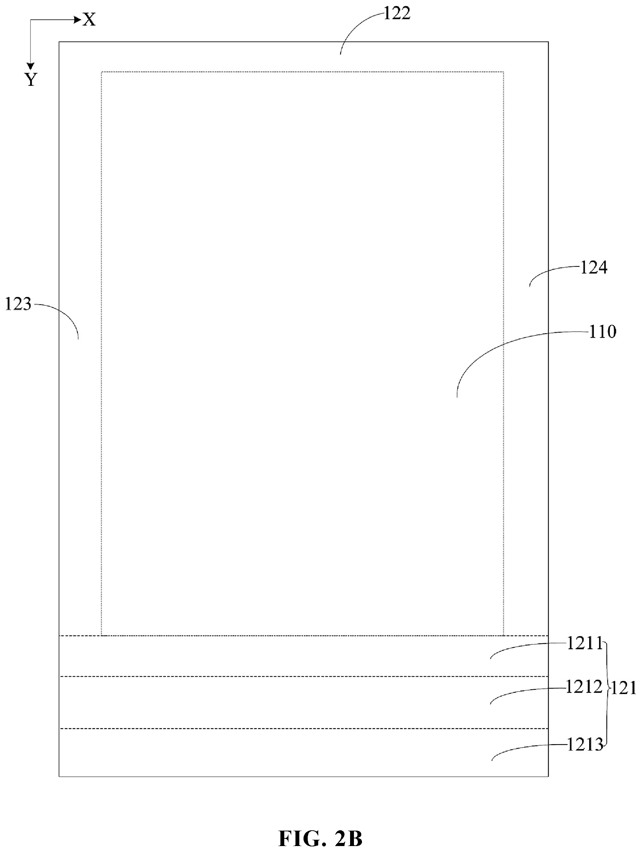

In one embodiment, as shown in FIG. 2B, the display substrate includes a display area 110 and a non-display area 120 on at least a side of the display area 110. In the embodiment shown in FIG. 2, the non-display area 120 surrounds the display area 110, and the non-display area 120 includes a non-display subarea 121, a non-display subarea 122, a non-display subarea 123, and a non-display subarea 124, where the non-display subarea 121 is opposite to the non-display subarea 122, and the non-display subarea 123 is opposite to the non-display subarea 124. A direction pointing from the display area 110 to the non-display subarea 121 is a first direction Y.

In one embodiment, as shown in FIGs. 1 and 2B, the non-display subarea 121 includes a transition area 1211, a bending area 1212 and a bonding area 1213. The bending area 1212 adjoins the transition area 1211 and the bonding area 1213, and the display area 110 is adjacent to the transition area 1211. When the display substrate is bent, a portion of the display substrate in the bending area 1212 is bent, and the bonding area 1213 is on a side of the display area 110 away from the display surface.

In one embodiment, the display substrate includes a plurality of bonding terminals in the bonding area 1213. The touch signal line 10, the shield line 20 and other traces are connected to the bonding terminals which may be bound to a flexible printed circuit (FPC), so that a chip connected to the FPC can provide signals to the traces.

In one embodiment, at least part of the first shield section 21 and the first section 11 are in the transition area 1211, and the second section 12 and the two second shield sections 22 are in the transition area 1211, the bending area 1212 and the bonding area 1213. In the embodiment shown in FIG. 1, the first shield section 21 and the first section 11 are only in the transition area 1211.

In one embodiment, as shown in FIG. 3, at least part of a section of the touch signal line 10 in the transition area 1211 includes a first touch signal part 102 and a second touch signal part 103 on a side of the first touch signal part 102 away from the substrate. At least part of a section of the shield line 20 in the transition area 1211 includes a first shield part 201, and a second shield part 202 on a side of the first shield part 201 away from the substrate. The first touch signal part 102 and the first shield part 201 are in the third conductive layer 31 of the touch layer, while the second touch signal part 103 and the second shield part 202 are in the fourth conductive layer 32 of the touch layer. In this manner, the resistances of the touch signal line 10 and the shield line 20 can be reduced.

In one embodiment, at least part of a section of the touch signal line 10 in the bonding area 1213 includes a first touch signal part and a second touch signal part on a side of the first touch signal part away from the substrate. At least part of a section of the shield line in the bonding area 1213 includes a first shield part, and a second shield part on a side of the first shield part away from the substrate. The first touch signal part and the first shield part are in the third conductive layer of the touch layer, while the second touch signal part and the second shield part are in the fourth conductive layer of the touch layer. In this manner, the resistances of the touch signal line 10 and the shield line 20 can be further reduced.

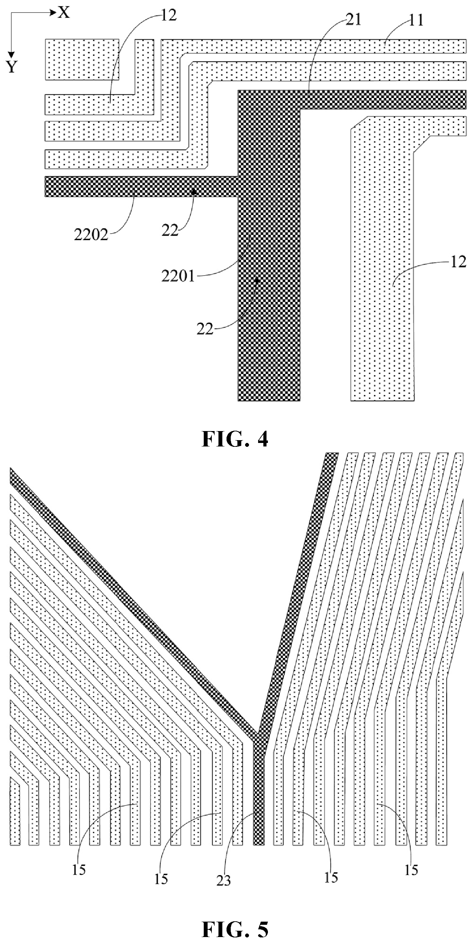

In one embodiment, as shown in FIGs. 1 and 4, the first shield section 21 is between two adjacent touch signal line groups 101, and in the same shield line 20, the two second shield sections 22 are directly connected to the first shield section 21. Since the first shield section 21 is between two adjacent touch signal line groups 101, the two second shield sections 22 may be directly connected to the first shield section 21, thereby simplifying the structure and the manufacturing process of the shield line 20.

In one embodiment, as shown in FIGs. 1 and 5, the shield line 20 further includes a third shield section 23 in the bonding area 1213 and between two adjacent touch signal line groups 101. In the same shield line 20, the two second shield sections 22 are each directly connected to a same third shield section 23. The third shield section 23 is connected to the bonding terminal. In this manner, the two second shield sections 22 are both connected to the bonding terminal through the third shield section 23, which can help to simplify the trace complexity of the display substrate.

In one embodiment, as shown in FIGs. 1 and 5, the touch signal line 10 further includes a third section 15 in the bonding area 1213 and connected to the bonding terminal. A maximum distance between third sections 15 in two adjacent touch signal line groups 101 is less than a maximum distance between second sections 12 in two adjacent touch signal line groups 101. The third shield section 23 is between third sections 15 in two touch signal line groups. By arranging the third shield section 23 between two third sections 15, signal crosstalk between the third sections 15 on opposite sides of the third shield section 23 can be prevented.

In one embodiment, as shown in FIG. 4, in view of portions of the second shield section 22 in the transition area 1211, a width of a portion 2201 of the second shield section 22 extending in the first direction Y is greater than a width of a portion 2202 of the second shield section 22 extending in a second direction X intersecting the first direction Y. This arrangement can help to reduce the width of the transition area 1211 in the first direction Y, and further reduce the bezel width of the display substrate. In the embodiment shown in FIG. 4, the second direction X is perpendicular to the first direction Y. In other embodiments, the second direction X and the first direction Y may form an acute angle.

In one embodiment, in view of portions of the touch signal lines 10 in the transition area 1211, a width of a portion of the touch signal line 10 extending in the first direction Y is greater than a width of a portion of the touch signal line 10 extending in a second direction X intersecting the first direction Y. This arrangement can help to reduce the width of the transition area 1211 in the first direction Y, and further reduce the bezel width of the display substrate.

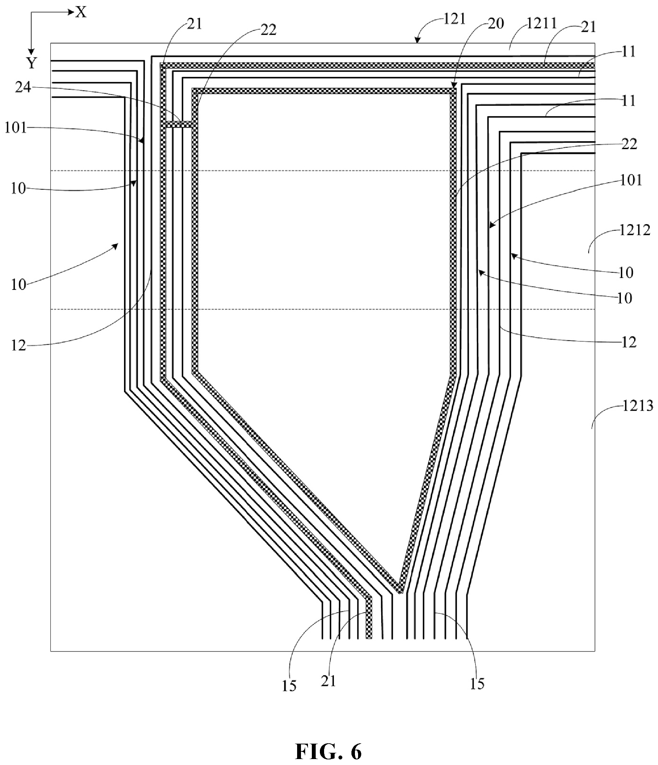

In one embodiment, as shown in FIGs. 6 to 8, the first shield section 21 is between two adjacent touch signal lines 10 in the same touch signal line group 101, and the shield line 20 further includes a connection section 24 connecting the first shield section 21 and the two second shield sections 22. The first shield section 21 is connected to the bonding terminal. In this manner, the two second shield sections 22 are connected to the first shield section 21 through the connection section 24, so that the first shield section 21 can transmit a signal from the chip to the two second shield sections 22 without connecting the two second shield sections 22 to a bonding terminal, which helps to reduce the number of bonding terminals.

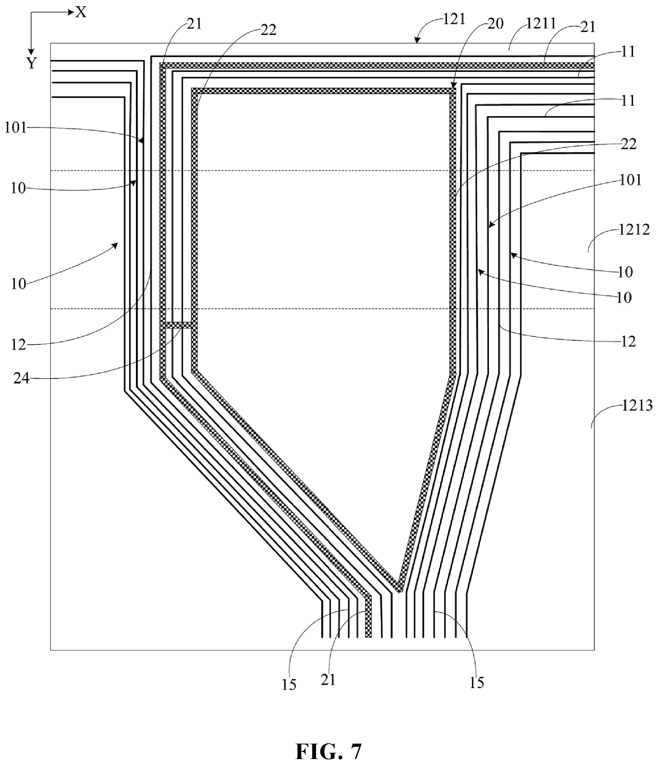

Further, as shown in FIGs. 6 and 7, in the same shield line 20, the two second shield sections 22 are connected with each other, and the connection section 24 is connected to one of the two second shield sections 22. This helps to simplify the trace complexity of the display substrate.

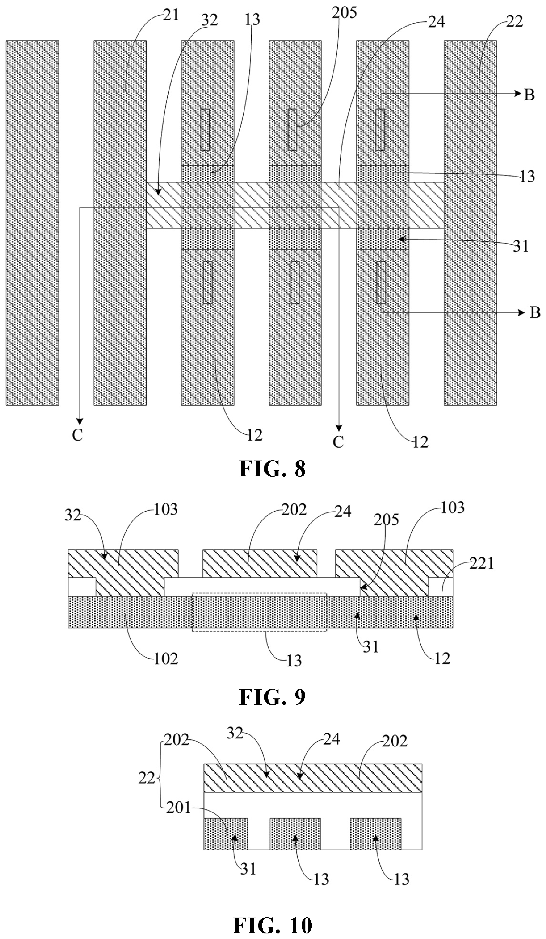

In one embodiment, as shown in FIGs. 8 and 9, the first shield section 21 is partially between two adjacent second sections 12 in the same touch signal line group 101, the second section 12 between the second shield section 22 connected to the connection section 24 and the first shield section 21 includes a first sub-section 13, and an orthographic projection of the first sub-section 13 on the substrate is overlapped with an orthographic projection of the connection section 24 on the substrate. The first sub-section 13 is in a different conductive layer from the connection section 24. This can prevent a short circuit between the connection section 24 and the first sub-section 13.

In one embodiment, as shown in FIGs. 8 to 10, the connection section 24 is in the fourth conductive layer 32, and the first sub-section 13 is in the third conductive layer 31. In other words, the first sub-section 13 includes only the first touch signal part 102, and the connection section 24 includes only the second shield part 202. In other embodiments, the connection section 24 may be in the third conductive layer, and the first sub-section 13 may be in the fourth conductive layer. The first insulation layer 247 has a through hole 205, and portions of the second section 12 in the fourth conductive layer 32 and on both sides of the connection section 24 are electrically connected to the third conductive layer 31 via the through hole 205, respectively.

Further, as shown in FIG. 6, the connection section 24 is in the transition area 1211. In another embodiment, as shown in FIG. 7, the connection section 24 is in the bonding area 1213. To facilitate the bending of the display substrate in the bending area, the bending area has a relatively small thickness, the touch layer is generally hollowed out in the bending area, and the portion of the touch signal line in the bending area is disposed in the conductive layer of the pixel circuit layer, so that the connection section 24 and the first sub-section 13 are in the bonding area or the transition area when being disposed in the touch layer.

In one embodiment, the first sub-section 13 is in the first conductive layer; and the connection section 24 is in the conductive layer of the touch layer. This arrangement can allow a relatively large distance between the first sub-section 13 and the connection section 24 in a direction perpendicular to the substrate, so that the signal interference of the connection section 24 with the touch signal line 10 is reduced, and the touch precision of the display substrate is favorably improved. Further, since the first sub-section 13 is in the first conductive layer of the pixel circuit layer, the first sub-section 13 can be formed simultaneously with the structure of the pixel circuit layer, which will not increase the process complexity of the display substrate.

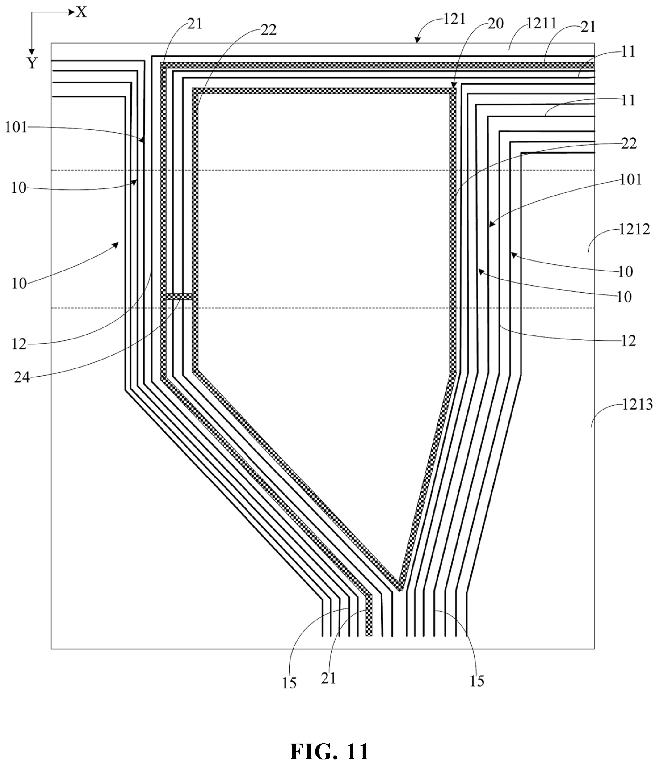

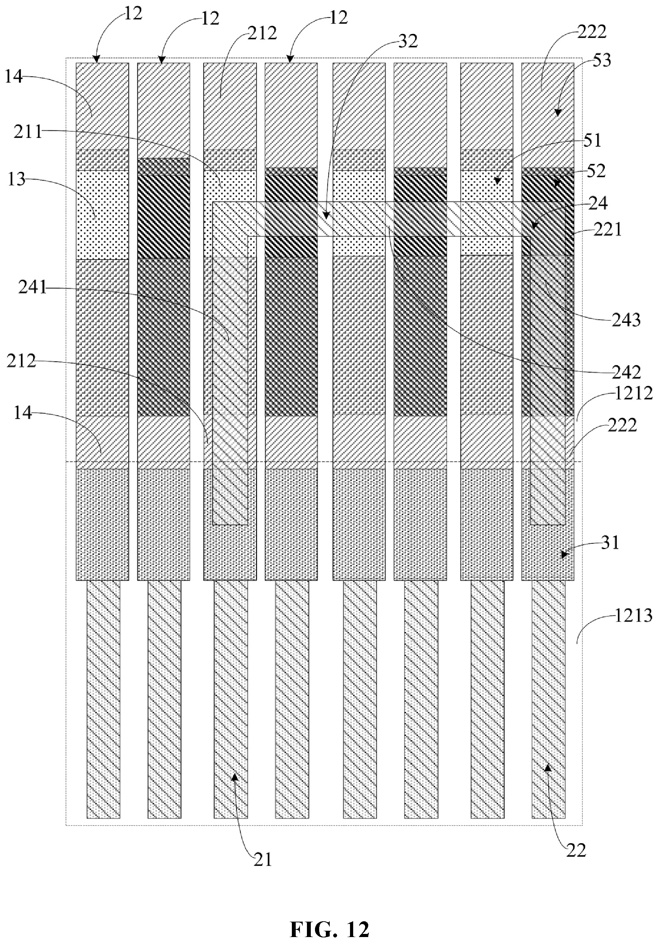

Further, as shown in FIGs. 11 and 12, the first sub-section 13 and the connection section 24 are in the bending area 1212. Specifically, the first sub-section 13 and the connection section 24 are in an edge area of the bending area 1212 close to the bonding area 1213. Since the portions of the touch signal line and the shield line in the bending area are disposed in the conductive layer of the pixel circuit layer, the first sub-section 13 disposed in the first conductive layer of the pixel circuit layer will not increase the manufacturing process complexity of the display substrate.

In one embodiment, as shown in FIG. 12, the second section 12 further includes a second sub-section 14 in the bending area 1212 and connected to the first sub-section 13; and the second sub-section 14 is in the second conductive layer 53. Since the distance between the first conductive layer and the touch layer is greater than the distance between the second conductive layer and the touch layer, the first sub-section 13 disposed in the first conductive layer can allow a larger distance between the first sub-section 13 and the connection section 24 in the direction perpendicular to the substrate, thereby further reducing the signal interference of the connection section 24 with the touch signal line 10. Since the second sub-section 14 is in the second conductive layer of the pixel circuit layer, the second sub-section 14 can be formed simultaneously with the structure of the pixel circuit layer, which will not increase the process complexity of the display substrate.

In one embodiment, as shown in FIG. 12, a portion of the touch signal lines 10 in the bending area 1212 includes two second sub-sections 14 connected to two ends of the first sub-section 13, respectively. By providing the first sub-section 13 of the touch signal line 10 in the bending area 1212 on a side of the second sub-sections 14 facing the substrate, the interference of static electricity with the touch signal line 10 can be improved.

In one embodiment, as shown in FIG. 12, the connection section 24 is in the fourth conductive layer 32 of the touch layer. This allows a larger distance between the first sub-section 13 and the connection section 24 in the direction perpendicular to the substrate, and can further reduce the signal interference of the connection section 24 with the touch signal line 10, thereby improving the touch precision of the display substrate.

In one embodiment, as shown in FIG. 12, the first conductive layer of the pixel circuit layer includes a first conductive sub-layer 51 and a second conductive sub-layer 52. Some first sub-sections 13 are in the first conductive sub-layer 51, and other first sub-sections 13 are in the second conductive sub-layer 52.

In one embodiment, as shown in FIG. 12, a portion of the second shield section 22 in the bending area 1212 includes a third sub-section 221 and a fourth sub-section 222 connected with each other. The third sub-section 221 is in the first conductive layer, and the fourth sub-section 222 is in the second conductive layer 53. In the embodiment shown in FIG. 12, the third sub-section 221 is in the first conductive sub-layer 51 of the first conductive layer. This arrangement can help to improve the interference of static electricity with the shield line 20.

In one embodiment, as shown in FIG. 12, a portion of the second shield section 22 in the bending area 1212 includes two fourth sub-sections 222 connected to two ends of the third sub-section 221, respectively.

In one embodiment, as shown in FIG. 12, a portion of the first shield section 21 in the bending area 1212 includes a fifth sub-section 211 and a sixth sub-section 212 connected with each other. The fifth sub-section 211 is in the first conductive layer, and the sixth sub-section 212 is in the second conductive layer 53. In the embodiment shown in FIG. 12, the fifth sub-section 211 is in the second conductive sub-layer 52 of the first conductive layer. This arrangement can help to improve the interference of static electricity with the shield line 20.

In one embodiment, as shown in FIG. 12, a portion of the first shield section 21 in the bending area 1212 includes two sixth sub-sections 212 connected to two ends of the fifth sub-section 211, respectively.

In one embodiment, as shown in FIG. 12, in view of portions of two adjacent traces in the first conductive layer, the portion of one trace in the first conductive layer is in the first conductive sub-layer 51, while the portion of the other trace in the first conductive layer is in the second conductive sub-layer 52. In this manner, a short circuit between the portions of adjacent traces in the first conductive layer can be avoided.

In one embodiment, as shown in FIG. 12, the connection section 24 includes a first connection sub-section 241, a second connection sub-section 242 and a third connection sub-section 243 sequentially connected. An orthographic projection of the second connection sub-section 242 on the substrate is overlapped with an orthographic projection of the first sub-section 13 on the substrate. An orthographic projection of the first connection sub-section 241 on the substrate falls in an orthographic projection of the first shield section 21 on the substrate. An orthographic projection of the third connection sub-section 243 on the substrate falls in an orthographic projection of the second shield section 22 on the substrate. Since the same signal is applied to the first connection sub-section 241, the third connection sub-section 243, the first shield section 21 and the second shield section 22, no interference will be generated between the first connection sub-section 241 and the first shield section 21, and no interference will be generated between the third connection sub-section 243 and the second shield section 22.

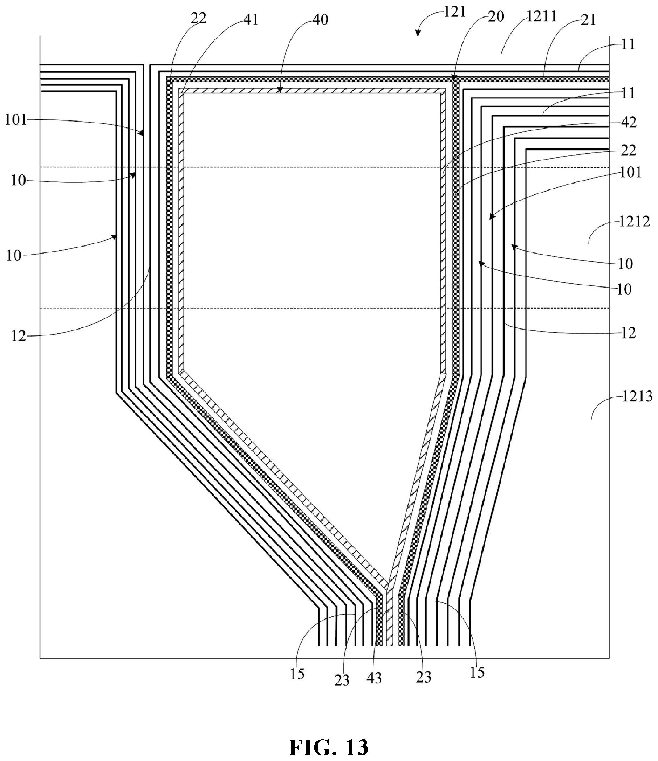

In one embodiment, as shown in FIG. 13, the display substrate further includes a ground signal line 40 including a first ground signal section 41 and a second ground signal section 42. The first ground signal section 41 and the second ground signal section 42 are between the two second shield sections 22 of the same shield line 20, and adjacent to different second shield sections 22, respectively. With such an arrangement, the first ground signal section 41 and the second ground signal section 42 can further reduce the interference of static charges and other signal lines with the touch signal line, thereby further improving the touch precision of the display substrate.

In one embodiment, at least part of a section of the ground signal line 40 in the bonding area 1213 includes a first ground part and a second ground part on a side of the first ground part away from the substrate. The first ground part is in the third conductive layer of the touch layer, while the second ground part is in the fourth conductive layer of the touch layer. This helps to further reduce the resistance of the ground signal line 40.

In one embodiment, as shown in FIG. 13, the ground signal line 40 further includes a third ground signal section 43. The first ground signal section 41 and the second ground signal section 42 are each connected to the same third ground signal section 43, and the third ground signal section is connected to the bonding terminal. In this manner, the trace complexity of the display substrate can be simplified.

Further, as shown in FIG. 13, the shield line 20 includes a third shield section 23 in the bonding area 1213 and adjacent to the third ground signal section 43. In this manner, the third ground signal section can further improve the signal crosstalk between the touch signal lines on both sides of the third ground signal section.

Further, as shown in FIG. 13, the shield line 20 includes two third shield sections 23, between which the third ground signal section 43 is located.

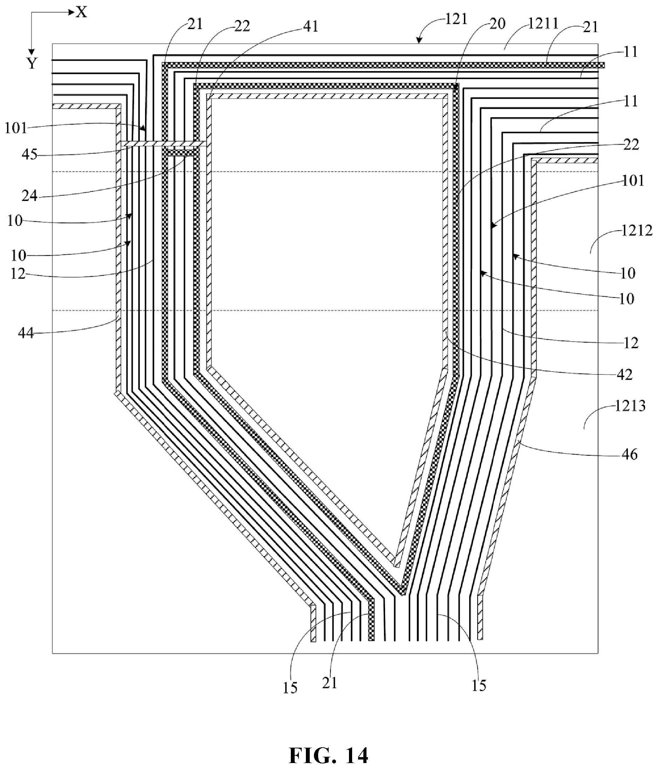

In one embodiment, as shown in FIG. 14, the ground signal line 40 includes a first ground signal section 41, a second ground signal section 42, a fourth ground signal section 44, and a fifth ground signal section 45. The first ground signal section 41 is connected to the second ground signal section 42. The first ground signal section 41 and the second ground signal section 42 are between the two second shield sections 22 of the same shield line 20, and adjacent to different second shield sections 22, respectively. The fourth ground signal section 44 is on a same side of the at least two touch signal line groups. The fourth ground signal section 44 can shield interference of external static electricity and other signal lines with the touch signal line.

Further, as shown in FIG. 14, the fourth ground signal section 44 is connected to the first ground signal section 41 through the fifth ground signal section 45; and the fourth ground signal section 44 is connected to the bonding terminal. In this manner, the same signal is applied to the first ground signal section 41, the second ground signal section 42, the fourth ground signal section 44, and the fifth ground signal section 45, and a signal section for connecting the first ground signal section and the second ground signal section to the bonding terminal can be omitted, which can help to simplify the trace complexity.

Further, as shown in FIG. 14, the ground signal line 40 further includes a sixth ground signal section 46, and the sixth ground signal section 46 and the fourth ground signal section 44 are on opposite sides of the at least two touch signal line groups 101. The sixth ground signal section 46 can further improve the interference with the touch signal line. The sixth ground signal section 46 may be electrically connected to the fourth ground signal section 44. For example, the display substrate may include a shield ring at a periphery of the display area, and the sixth ground signal section 46 and the fourth ground signal section 44 are parts of the shield ring, respectively.

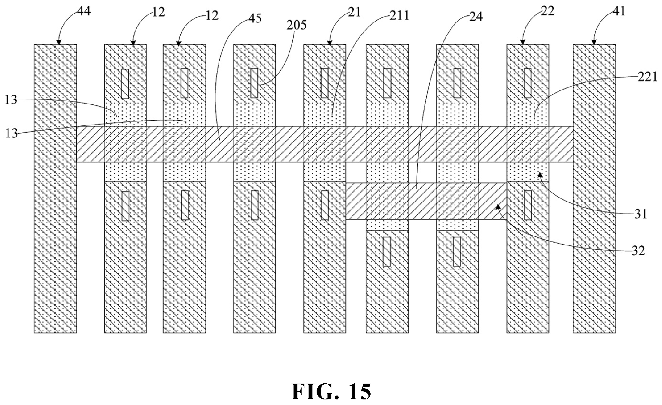

In one embodiment, as shown in FIG. 15, the second section 12 includes a first sub-section 13. The second shield section 22 includes a third sub-section 221. The first shield section 21 includes a fifth sub-section 211. An orthographic projection of the fifth ground signal section 45 on the substrate is overlapped with orthographic projections of the first sub-section 13, the third sub-section 221, and the fifth sub-section 211 on the substrate, and the fifth ground signal section 45, the first sub-section 13, the third sub-section 221, and the fifth sub-section 211 are in different conductive layers, respectively, to avoid a short circuit. The first insulation layer 247 has a through hole 205, and portions of the second section 12, the first shield section 21, and the second shield section 22 in the fourth conductive layer 32 and on both sides of the connection section 24 are all electrically connected to the third conductive layer 31 via the through hole 205.

In one embodiment, the fifth ground signal section 45 is in the fourth conductive layer, and the first sub-section 13, the third sub-section 221, and the fifth sub-section 211 are in the third conductive layer; or the fifth ground signal section 45 is in the third conductive layer, and the first sub-section 13, the third sub-section 221, and the fifth sub-section 211 are in the fourth conductive layer.

Further, as shown in FIG. 14, the fifth ground signal section 45, the first sub-section 13, the third sub-section 221, and the fifth sub-section 211 are in the transition area 1211. In other embodiments, the fifth ground signal section 45, the first sub-section 13, the third sub-section 221, and the fifth sub-section 211 may be in the bonding area 1213. To facilitate the bending of the display substrate in the bending area, the bending area has a relatively small thickness, the touch layer is generally hollowed out in the bending area, and the portion of the touch signal line in the bending area is disposed in the conductive layer of the pixel circuit layer. Therefore, when the fifth ground signal section 45, the first sub-section 13, the third sub-section 221, and the fifth sub-section 211 are disposed in the touch layer, the fifth ground signal section 45, the first sub-section 13, the third sub-section 221, and the fifth sub-section 211 are in the bonding area or the transition area.

In one embodiment, the first sub-section 13, the third sub-section 221, and the fifth sub-section 211 are in the first conductive layer, and the fifth ground signal section is in a conductive layer in the touch layer. This arrangement allows relatively large distances from the fifth ground signal section 45 to the first sub-section 13, the third sub-section 221, and the fifth sub-section 211 in the direction perpendicular to the substrate, so that signal interference of the fifth ground signal section 45 with the touch signal line 10 and the shield line can be reduced, and the touch precision of the display substrate is favorably improved. Further, since the first sub-section 13, the third sub-section 221 and the fifth sub-section 211 are in the first conductive layer of the pixel circuit layer, the first sub-section 13, the third sub-section 221 and the fifth sub-section 211 are all formed simultaneously with the structure of the pixel circuit layer, which will not increase the process complexity of the display substrate.

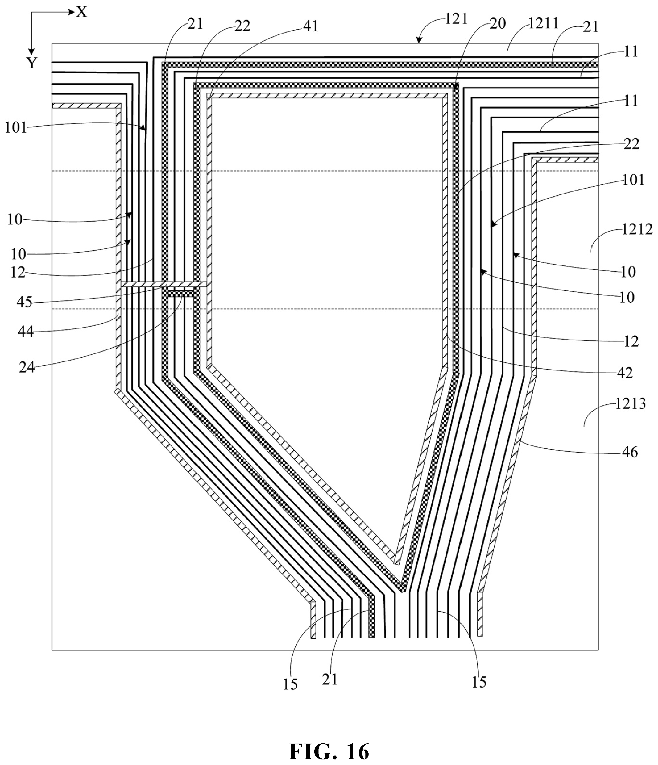

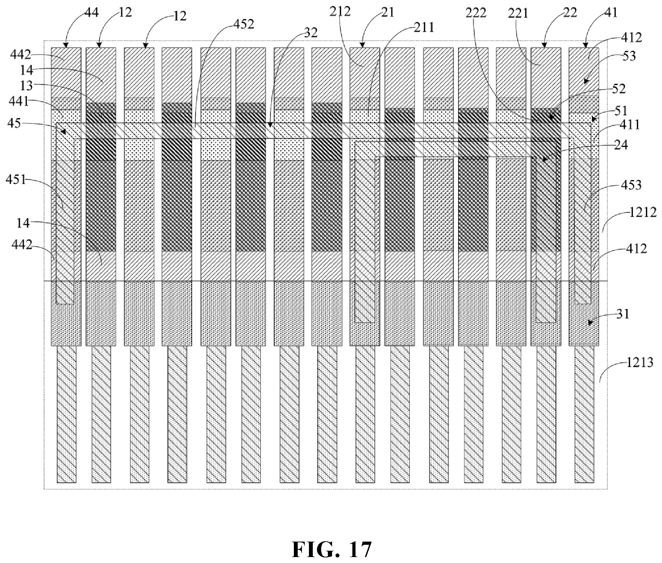

Further, as shown in FIGs. 16 and 17, the first sub-section 13, the third sub-section 221, the fifth sub-section 211 and the fifth ground signal section 45 are in the bending area 1212. Specifically, the first sub-section 13, the third sub-section 221, the fifth sub-section 211 and the fifth ground signal section 45 are in an edge area of the bending area 1212 close to the bonding area 1213. Since the portions of the touch signal line, the ground signal line and the shield line in the bending area are disposed in the conductive layer of the pixel circuit layer, the first sub-section 13, the third sub-section 221 and the fifth sub-section 211 provided in the first conductive layer of the pixel circuit layer will not increase the manufacturing process complexity of the display substrate. The connection section 24 may be in the bending area 1212, and the fifth ground signal section 45 and the connection section are in an edge area of the bending area 1212 adjacent to the bonding area 1213.

Further, as shown in FIG. 17, the fifth ground signal section 45 is in the fourth conductive layer 32. This arrangement allows larger distances from the fifth ground signal section 45 to the first sub-section 13, the fourth sub-section 222 of the second shield section 22, and the sixth sub-section 212 of the first shield section 21 in the direction perpendicular to the substrate.

Further, as shown in FIG. 17, the fifth ground signal section 45 includes a first ground signal sub-section 451, a second ground signal sub-section 452, and a third ground signal sub-section 453 sequentially connected. An orthographic projection of the second ground signal sub-section 452 on the substrate is overlapped with orthographic projections of the first sub-section 13, the fourth sub-section 222, and the sixth sub-section 212 on the substrate. An orthographic projection of the first ground signal sub-section 451 on the substrate falls in an orthographic projection of the fourth ground signal section 44 on the substrate. An orthographic projection of the third ground signal sub-section 453 on the substrate falls in an orthographic projection of the first ground signal section 41 on the substrate. Since the same signal applied to the first ground signal sub-section 451, the fourth ground signal section 44, the third ground signal sub-section 453, and the first ground signal section 41, no interference will be generated between the first ground signal sub-section 451 and the fourth ground signal section 44, and no interference will be generated between the third ground signal sub-section 453 and the first ground signal section 41.

In one embodiment, as shown in FIG. 17, the second section 12 further includes a second sub-section 14 in the bending area 1212 and connected to the first sub-section 13; and the second sub-section 14 is in the second conductive layer 53. Since the distance between the first conductive layer and the touch layer is greater than the distance between the second conductive layer and the touch layer, the first sub-section 13 disposed in the first conductive layer can allow a larger distance between the first sub-section 13 and the fifth ground signal section 45 in the direction perpendicular to the substrate, thereby further reducing the signal interference of the fifth ground signal section 45 with the touch signal line 10. Since the second sub-section 14 is in the second conductive layer of the pixel circuit layer, the second sub-section 14 can be formed simultaneously with the structure of the pixel circuit layer, which will not increase the process complexity of the display substrate.

In one embodiment, as shown in FIG. 17, a portion of the fourth ground signal section 44 in the bending area 1212 includes a seventh sub-section 441 and an eighth sub-section 442 connected with each other. The seventh sub-section 441 is in the first conductive layer, and the eighth sub-section 442 is in the second conductive layer 53. In the embodiment shown in FIG. 17, the seventh sub-section 441 is in the first conductive sub-layer 51 of the first conductive layer. This arrangement can help to improve the interference of static electricity with the ground signal line 40.

In one embodiment, as shown in FIG. 17, a portion of the fourth ground signal section 44 in the bending area 1212 includes two eighth sub-sections 442 connected to two ends of the seventh sub-section 441, respectively.

In one embodiment, as shown in FIG. 17, a portion of the first ground signal section 41 in the bending area 1212 includes a ninth sub-section 411 and a tenth sub-section 412 connected with each other. The ninth sub-section 411 is in the first conductive layer, and the tenth sub-section 412 is in the second conductive layer 53. In the embodiment shown in FIG. 17, the ninth sub-section 411 is in the first conductive sub-layer 51 of the first conductive layer. This arrangement can help to improve the interference of static electricity with the ground signal line 40.

In one embodiment, as shown in FIG. 17, a portion of the first ground signal section 41 in the bending area 1212 includes two tenth sub-sections 412 connected to two ends of the ninth sub-section 411, respectively.

In one embodiment, as shown in FIG. 17, in view of portions of two adjacent traces in the first conductive layer, the portion of one trace in the first conductive layer is in the first conductive sub-layer 51, while the portion of the other trace in the first conductive layer is in the second conductive sub-layer 52. In this manner, a short circuit between the portions of adjacent traces in the first conductive layer can be avoided.

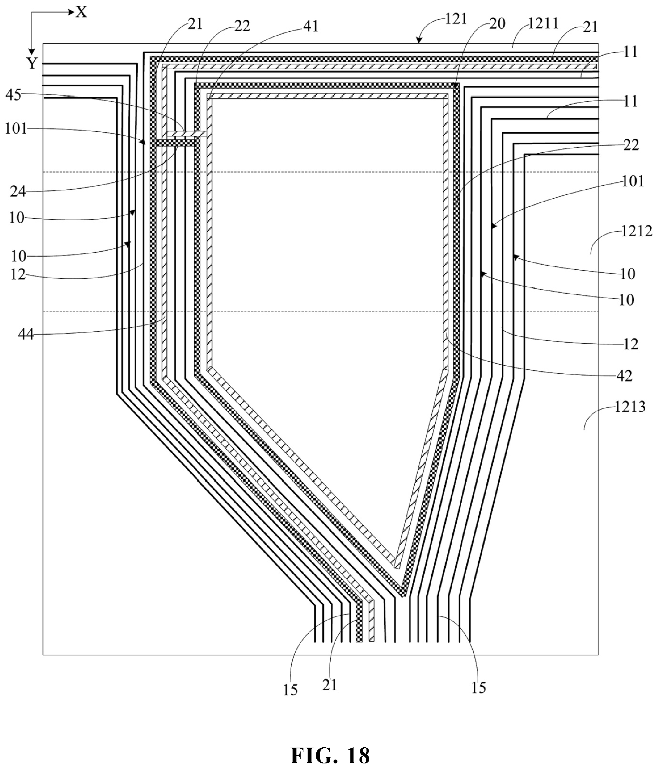

In one embodiment, as shown in FIG. 18, the ground signal line 40 includes a first ground signal section 41, a second ground signal section 42, a fourth ground signal section 44, and a fifth ground signal section 45. The first ground signal section 41 is connected to the second ground signal section 42. The first ground signal section 41 and the second ground signal section 42 are between the two second shield sections 22 of the same shield line 20, and adjacent to different second shield sections 22, respectively. The fourth signal section 44 is between two adjacent touch signal lines 10 in the same touch signal line group 101 and adjacent to the first shield section 21, and the fourth ground signal section 44 is connected to the first ground signal section 41 through the fifth ground signal section 45; and the fourth ground signal section 44 is connected to the bonding terminal. By providing the fourth ground signal section 44 between two adjacent touch signal lines 10 and adjacent to the first shield section 21, the signal crosstalk between the touch signal lines connected to different types of touch electrodes can be further avoided. Since the first ground signal section 41 is connected to the fourth ground signal section 44 through the fifth ground signal section 45, and the fourth ground signal section 44 is connected to a driver chip through the bonding terminal, the first ground signal section 41 does not need to be connected to a bonding terminal, thereby reducing the number of bonding terminals.

In one embodiment, as shown in FIG. 18, the fourth signal section 44 is partially between two adjacent first sections 11, partially between two adjacent second sections 12, and partially between two adjacent third sections 15, and the portion between two adjacent second sections 12 is connected to the portion between two adjacent first sections 11 and the portion between two adjacent third sections 15, respectively. In this manner, the signal crosstalk between the touch signal lines connected to different types of touch electrodes can be further improved.

In one embodiment, as shown in FIG. 18, the fifth ground signal section 45 and the connection section 24 are in the transition area 1211. In other embodiments, the fifth ground signal section 45 and the connection section 24 may be in the bonding area 1213. The film layer layouts of the ground signal line 40, the touch signal line 10 and the shield line 20 are similar to those in the embodiment of FIG. 15, and are not repeated here.

In another embodiment, the fifth ground signal section 45 and the connection section 24 are in the bending area 1212. The film layer layouts of the ground signal line 40, the touch signal line 10 and the shield line 20 are similar to those in the embodiment of FIG. 17, and are not repeated here.

An embodiment of the present application further provides a display apparatus. The display apparatus includes the display substrate according to any one of the above embodiments.

In one embodiment, the display apparatus further includes a power circuit configured to supply power to the display substrate.

In one embodiment, the display apparatus further includes a housing in which the display substrate is disposed.

The display apparatus provided in the embodiment of the present application may be, for example, a mobile phone, a tablet, a television, a laptop, a vehicle-mounted device, or any other device having a display touch function.

It should be noted that in the drawings, sizes of the layers and areas may be exaggerated for clarity of illustration. Moreover, it will be understood that when an element or layer is referred to as being "on" another element or layer, it may be directly on the other element or layer, or intervening layers may be present. In addition, it will be understood that when an element or layer is referred to as being "under" another element or layer, it may be directly under the other element or more than one intervening layer or element may be present. In addition, it will be further understood that when a layer or element is referred to as being "between" two layers or elements, it may be the only layer between the two layers or elements, or more than one intervening layer or element may be present. Like reference numerals refer to like elements throughout the disclosure.

Other implementations of the present application will be apparent to those skilled in the art from consideration of the description and practice of the present disclosure disclosed herein. The present application is intended to cover any variations, uses, or adaptations of the present application which follow general principles of the present application and include common knowledge or conventional technical means in the art that are not disclosed herein. The description and the embodiments are intended to be considered as exemplary only, with a true scope and spirit of the present application being indicated by the following claims.

It will be appreciated that the present application is not limited to the precise structures as described above and shown in the drawings, and that various modifications and changes may be made without departing from the scope of the present disclosure. The scope of the present application is defined only by the appended claims.

## Claims

1. A display substrate, comprising:
a substrate;
a light-emitting structure layer on a side of the substrate;
a touch layer on a side of the light-emitting structure layer away from the substrate, wherein the touch layer comprises a plurality of touch electrodes;
at least two touch signal line groups, each of which comprises a plurality of touch signal lines, wherein all touch signal lines are electrically connected to the plurality of touch electrodes, respectively, at least part of the touch signal lines each comprise a first section and a second section connected with each other, and second sections in a same touch signal line group are adjacent to each other; and
a shield line, comprising a first shield section and two second shield sections, wherein the first shield section is at least partially between two adjacent first sections, and each second shield section is in a gap between second sections in two adjacent touch signal line groups; and in two adjacent touch signal line groups, the second section in one touch signal line group adjacent to the other touch signal line group is adjacent to one of the two second shield sections, while the two second shield sections are electrically connected to the first shield section.

2. The display substrate according to claim 1, wherein the first shield section is between two adjacent touch signal lines in the same touch signal line group, and the shield line further comprises a connection section connecting the first shield section and the two second shield sections; and the display substrate further comprises a bonding terminal connected to the first shield section.

3. The display substrate according to claim 2, wherein the first shield section is partially between two adjacent second sections in the same touch signal line group, the second section between the second shield section connected to the connection section and the first shield section comprises a first sub-section, and an orthographic projection of the first sub-section on the substrate is overlapped with an orthographic projection of the connection section on the substrate; and the first sub-section is in a different conductive layer from the connection section.

4. The display substrate according to claim 2, wherein in a same shield line, the two second shield sections are connected with each other, and the connection section is connected to one of the two second shield sections.

5. The display substrate according to claim 3, wherein the display substrate further comprises a first conductive layer between the light-emitting structure layer and the substrate, and the first sub-section is in the first conductive layer; and the connection section is in a conductive layer in the touch layer.

6. The display substrate according to claim 5, wherein the display substrate comprises a display area and a non-display area, wherein the non-display area comprises a transition area, a bending area and a bonding area, the bending area adjoins the transition area and the bonding area, and the display area is adjacent to the transition area; the bonding area is on a side of the display area facing away from a display surface; the first section and at least part of the first shield section is in the transition area, and the second section and the two second shield sections are in the transition area, the bending area and the bonding area; and the first sub-section and the connection section are in the bending area; and
the display substrate further comprises a second conductive layer between the first conductive layer and the light-emitting structure layer; the second section further comprises a second sub-section in the bending area and connected to the first sub-section; and the second sub-section is in the second conductive layer.

7. The display substrate according to claim 5, wherein the touch layer comprises a third conductive layer, and a fourth conductive layer on a side of the third conductive layer away from the substrate; and the connection section is in the fourth conductive layer.

8. The display substrate according to claim 5, wherein the display substrate further comprises a plurality of pixel circuits between the light-emitting structure layer and the substrate, wherein part of structures of the pixel circuits are in the first conductive layer.

9. The display substrate according to claim 3, wherein the touch layer comprises a third conductive layer, and a fourth conductive layer on a side of the third conductive layer away from the substrate; wherein the connection section is in the third conductive layer, and the first sub-section is in the fourth conductive layer; or the connection section is in the fourth conductive layer, and the first sub-section is in the third conductive layer.

10. The display substrate according to claim 9, wherein the display substrate comprises a display area and a non-display area, wherein the non-display area comprises a transition area, a bending area and a bonding area, the bending area adjoins the transition area and the bonding area, and the display area is adjacent to the transition area; the bonding area is on a side of the display area facing away from a display surface; the first section and at least part of the first shield section is in the transition area, and the second section and the two second shield sections are in the transition area, the bending area and the bonding area; and
the connection section is in the transition area or the bonding area.

11. The display substrate according to claim 1, wherein the first shield section is between two adjacent touch signal line groups, and in a same shield line, the two second shield sections are directly connected to the first shield section.

12. The display substrate according to claim 11, wherein the display substrate comprises a display area and a non-display area, wherein the non-display area comprises a transition area, a bending area and a bonding area, the bending area adjoins the transition area and the bonding area, and the display area is adjacent to the transition area; the bonding area is on a side of the display area facing away from a display surface; the first section and at least part of the first shield section is in the transition area, and the second section and the two second shield sections are in the transition area, the bending area and the bonding area; and
the shield line further comprises a third shield section in the bonding area and between two adjacent touch signal line groups; in a same shield line, the two second shield sections are each directly connected to a same third shield section; and the display substrate further comprises a bonding terminal in the bonding area and connected to the third shield section.

13. The display substrate according to claim 1, wherein the display substrate further comprises a ground signal line comprising a first ground signal section and a second ground signal section, wherein the first ground signal section and the second ground signal section are between the two second shield sections of a same shield line, and adjacent to different second shield sections, respectively.

14. The display substrate according to claim 13, wherein the ground signal line further comprises a third ground signal section; the first ground signal section and the second ground signal section are each connected to a same third ground signal section, and the display substrate further comprises a bonding terminal connected to the third ground signal section.

15. The display substrate according to claim 14, wherein the display substrate comprises a display area and a non-display area, wherein the non-display area comprises a transition area, a bending area and a bonding area, the bending area adjoins the transition area and the bonding area, and the display area is adjacent to the transition area; the bonding area is on a side of the display area facing away from a display surface; the first section and at least part of the first shield section is in the transition area, and the second section and the two second shield sections are in the transition area, the bending area and the bonding area; and the bonding terminal is in the bonding area; and
the shield line further comprises a third shield section in the bonding area and connected to the bonding terminal and adjacent to the third ground signal section.

16. The display substrate according to claim 13, wherein the ground signal line further comprises a fourth ground signal section and a fifth ground signal section; the first ground signal section is connected to the second ground signal section; and the fourth ground signal section is on a same side of the at least two touch signal line groups, and connected to the first ground signal section through the fifth ground signal section; and
the display substrate further comprises a bonding terminal connected to the fourth ground signal section.

17. The display substrate according to claim 13, wherein the ground signal line comprises a fourth ground signal section and a fifth ground signal section; the first ground signal section is connected to the second ground signal section; and the fourth ground signal section is between two adjacent touch signal lines in the same touch signal line group and adjacent to the first shield section, and connected to the first ground signal section through the fifth ground signal section; and
the display substrate further comprises a bonding terminal connected to the fourth ground signal section.

18. The display substrate according to claim 16 or 17, wherein the display substrate further comprises a first conductive layer between the light-emitting structure layer and the substrate; the second section comprises a first sub-section, and the second shield section comprises a third sub-section; an orthographic projection of the fifth ground signal section on the substrate is overlapped with an orthographic projection of the first sub-section on the substrate, and overlapped with an orthographic projection of the third sub-section on the substrate; the first sub-section and the third sub-section are in the first conductive layer; and the fifth ground signal section is in a conductive layer in the touch layer.

19. The display substrate according to claim 18, wherein the display substrate comprises a display area and a non-display area, wherein the non-display area comprises a transition area, a bending area and a bonding area, the bending area adjoins the transition area and the bonding area, and the display area is adjacent to the transition area; the bonding area is on a side of the display area facing away from a display surface; the first section and at least part of the first shield section is in the transition area, and the second section and the two second shield sections are in the transition area, the bending area and the bonding area; and the first sub-section, the third sub-section and the fifth ground signal section are in the bending area; and
the display substrate further comprises a second conductive layer between the first conductive layer and the light-emitting structure layer; the second section further comprises a second sub-section in the bending area and connected to the first sub-section, and the second shield section further comprises a fourth sub-section in the bending area and connected to the third sub-section; and the second sub-section and the fourth sub-section are in the second conductive layer.

20. The display substrate according to claim 16 or 17, wherein the second section comprises a first sub-section; the second shield section comprises a third sub-section, and an orthographic projection of the fifth ground signal section on the substrate is overlapped with an orthographic projection of the first sub-section on the substrate, and overlapped with an orthographic projection of the third sub-section on the substrate; and
the touch layer comprises a third conductive layer, and a fourth conductive layer on a side of the third conductive layer away from the substrate; and the fifth ground signal section is in the third conductive layer, and the first sub-section and the third sub-section are in the fourth conductive layer; or the fifth ground signal section is in the fourth conductive layer, and the first sub-section and the third sub-section are in the third conductive layer.

21. The display substrate according to claim 20, wherein the display substrate comprises a display area and a non-display area, wherein the non-display area comprises a transition area, a bending area and a bonding area, the bending area adjoins the transition area and the bonding area, and the display area is adjacent to the transition area; the bonding area is on a side of the display area facing away from a display surface; the first section and at least part of the first shield section is in the transition area, and the second section and the two second shield sections are in the transition area, the bending area and the bonding area; and
the fifth ground signal section is in the transition area or the bonding area.

22. The display substrate according to claim 1, wherein the plurality of touch electrodes comprise a plurality of first touch electrodes and a plurality of second touch electrodes, wherein one of each first touch electrode or each second touch electrode is a touch drive electrode, and the other is a touch sense electrode; the plurality of touch signal lines comprise a plurality of first touch signal lines and a plurality of second touch signal lines, wherein the first touch signal lines are connected to the first touch electrodes, and the second touch signal lines are connected to the second touch electrodes; and the first touch signal lines and the second touch signal lines in two adjacent touch signal line groups are on two sides of the first shield section.

23. The display substrate according to claim 1, wherein the display substrate comprises a display area and a non-display subarea on a side of the display area, wherein the shield line and the touch signal lines are in the non-display subarea; and a direction pointing from the display area to the non-display subarea is a first direction; and
each second shield section is in a portion of the non-display subarea, and a width of a portion of the second shield section extending in the first direction is greater than a width of a portion of the second shield section extending in a second direction intersecting the first direction; and/or each touch signal line is in a portion of the non-display subarea, and a width of a portion of the touch signal line extending in the first direction is greater than a width of a portion of the touch signal line extending in a second direction intersecting the first direction.

24. The display substrate according to claim 1, wherein each touch signal line further comprises a third section connected to an end of the second section away from the first section, and a maximum distance between third sections in two adjacent touch signal line groups is less than a maximum distance between second sections in two adjacent touch signal line groups; the shield line further comprises a third shield section between two adjacent third sections; and the display substrate further comprises bonding terminals connected to each third section and the third shield section.

25. A display apparatus, comprising the display substrate according to any one of claims 1 to 24.
